# EUROPEAN PATENT SPECIFICATION

(11) **EP 4 529 070 B1**
(45) Date of publication and mention of the grant of the patent: **09.09.2026**
(21) Application number: 23908957.6
(22) Date of filing: 12.05.2023
(51) Int. Cl.: H04B 1/00, H04B 1/18

(54) **RADIO FREQUENCY FRONT END DEVICE, ANTENNA MODULE, AND ELECTRONIC DEVICE**
HOCHFREQUENZ-FRONTENDVORRICHTUNG, ANTENNENMODUL UND ELEKTRONISCHE VORRICHTUNG
DISPOSITIF FRONTAL RADIOFRÉQUENCE, MODULE D'ANTENNE ET DISPOSITIF ÉLECTRONIQUE

(30) Priority: 27.12.2022 CN 202223555957 U
(43) Date of publication of application: 26.03.2025
(73) Proprietor: Honor Device Co., Ltd., Shenzhen, Guangdong 518040 (CN)
(72) Inventor: CHEN, Dan, Shenzhen, Guangdong 518040 (CN); HUANG, Qinghua, Shenzhen, Guangdong 518040 (CN)
(74) Representative: Goddar, Heinz J.
(86) International application number: PCT/CN2023/093971
(87) International publication number: WO 2024/139009

(56) References cited:
- CN-A- 106 209 120
- CN-A- 109 560 833
- CN-A- 111 565 057
- US-A1- 2016 126 994
- US-A1- 2019 013 790
- US-A1- 2020 358 516
- US-A1- 2022 069 849

## Description

This application claims priority to Chinese Patent Application No. 202223555957.1, filed with the China National Intellectual Property Administration on December 27, 2022 and entitled "RADIO FREQUENCY FRONT-END DEVICE, ANTENNA MODULE, AND ELECTRONIC DEVICE".

### TECHNICAL FIELD

This application relates to the field of radio frequency technologies, and in particular, to a radio frequency front-end device, an antenna module, and an electronic device.

### BACKGROUND

As wireless communication technologies (such as 5G) develop, to meet a demand for increasing a single-user peak rate and a system capacity, a transmission bandwidth in a radio frequency front-end device in an electronic device is usually increased through a carrier aggregation (Carrier Aggregation, CA) technology. To meet demands in different carrier aggregation states, an antenna switch (Antenna Switch, ASW) in the radio frequency front-end device usually includes a plurality of switches. The plurality of switches are respectively connected to filters with different operating bands in one-to-one correspondence. However, an existing antenna switch has many switches and complex circuits, which causes a high parasitic capacitance. In addition, a current radio frequency front-end device has poor tuning performance.

US 2016/126994 A1 discloses a diversity receiver front end system with variable-gain amplifiers. A receiving system can include a controller configured to selectively activate one or more of a plurality of paths between an input of a first multiplexer and an output of a second multiplexer. The receiving system can further include a plurality of bandpass filters, each one of the plurality of bandpass filters disposed along a corresponding one of the plurality of paths and configured to filter a signal received at the bandpass filter to a respective frequency band. The receiving system can further include a plurality of variable-gain amplifiers (VGAs), each one of the plurality of VGAs disposed along a corresponding one of the plurality of paths and configured to amplify a signal received at the VGA with a gain controlled by an amplifier control signal received from the controller.

US 2019/013790 A1 discloses a flexible multi-path RF adaptive tuning network switch architecture that counteracts impedance mismatch conditions arising from various combinations of coupled RF band filters, particularly in a Carrier Aggregation-based (CA) radio system. In one version, a digitally-controlled tunable matching network is coupled to a multi-path RF switch in order to provide adaptive impedance matching for various combinations of RF band filters. Optionally, some or all RF band filters include an associated digitally-controlled filter pre-match network to further improve impedance matching. In a second version, some or all RF band filters coupled to a multi-path RF switch include a digitally-controlled phase matching network to provide necessary per-band impedance matching. Optionally, a digitally-controlled tunable matching network may be included on the common port of the multi-path RF switch to provide additional impedance matching capability. In a third version, CA direct mapped adaptive tuning networks include filter tuning blocks for selected lower frequency bands.

### SUMMARY

To resolve the foregoing technical problems, this application provides a radio frequency front-end device, an antenna module, and an electronic device. A layout of switches is redesigned, which effectively reduces an area and a parasitic capacitance of an antenna switch. In addition, a matching circuit and a filter are arranged outside a radio frequency module, which improves a tuning freedom degree, thereby enabling the radio frequency front-end device to adapt to signals in different bands, and ensures operating performance in a carrier aggregation state of signals in different bands, thereby expanding an application range of the radio frequency front-end device.

According to a first aspect, this application provides a radio frequency front-end device. The radio frequency front-end device includes a radio frequency module and a first external filter and a first external matching circuit arranged outside the radio frequency module. The radio frequency module includes an antenna switch and a first filter, the antenna switch includes a first switch, a first end of the first switch is configured to connect to a common signal terminal of the radio frequency module, and a second end is connected to the first filter. The radio frequency module further includes a second switch, a first end of the second switch is connected to the second end of the first switch, and the first external filter and the first external matching circuit are separately connected to a second end of the second switch.

In the radio frequency front-end device, the matching circuit and the filter are arranged outside the radio frequency module, so that an area and a parasitic capacitance of the antenna switch can be effectively reduced, thereby improving operating performance of the antenna switch. In addition, free tuning of the matching circuit can be achieved, which meets carrier aggregation demands in different application scenarios.

In a possible implementation of the first aspect, the first switch is connected to the first filter through a first internal matching circuit arranged in the radio frequency module, and the first internal matching circuit has a first topology.

In a possible implementation of the first aspect, when the second switch is turned on, the first internal matching circuit and the first external matching circuit jointly form a matching circuit having a second topology, and the second topology is different from the first topology.

The above matching circuit has a high tuning freedom degree, and the matching circuit having different topologies can ensure signal transmission performance in a carrier aggregation state and a non-carrier aggregation state, and reduce a signal leakage possibility in the carrier aggregation state.

In a possible implementation of the first aspect, a third switch is further arranged between the second end of the first switch and the first filter, and the third switch is configured to control connection or disconnection between the second end of the first switch and the first filter.

In a carrier aggregation state of a plurality of signals, the third switch can effectively avoid interference between the signals, which effectively improves signal transmission performance of the radio frequency front-end device in the carrier aggregation state.

In a possible implementation of the first aspect, the radio frequency module is integrated on a same circuit board or a same chip. In this way, the radio frequency module may be used as an electronic component that may be purchased or sold alone.

In a possible implementation of the first aspect, the circuit board includes a first pin, and the first external filter and the first external matching circuit are separately connected to the second end of the second switch through the first pin.

In a possible implementation of the first aspect, the radio frequency front-end device further includes a second external filter and a second external matching circuit arranged outside the radio frequency module. The radio frequency module further includes a second filter. The antenna switch further includes a fourth switch, a first end of the fourth switch is configured to connect to the common signal terminal of the radio frequency module, and a second end is connected to the second filter. The radio frequency module further includes a fifth switch, a first end of the fifth switch is connected to the second end of the fourth switch, and the second external filter and the second external matching circuit are separately connected to a second end of the fifth switch.

In the implementations of this application, more switches (such as the fourth switch and the fifth switch), an external filter (such as the second external filter), and an external matching circuit (such as the second external matching circuit) are arranged, so that the radio frequency front-end device can achieve carrier aggregation of signals in more bands, to adapt to more different application scenarios. In this way, an application range of the radio frequency front-end device is expanded.

In a possible implementation of the first aspect, an operating band of the first filter includes one of the following: a B1 band, a B3 band, and a B7 band; and/or an operating band of the first external filter includes a B32 band.

In a possible implementation of the first aspect, the radio frequency module includes one or more common signal terminals.

According to a second aspect, this application provides an antenna module. The antenna module includes an antenna, a transceiver, and the radio frequency front-end device according to any one of the implementations of the first aspect. The common signal terminal of the radio frequency front-end device is connected to the antenna, and the filter of the radio frequency front-end device is connected to the transceiver.

According to a third aspect, this application provides an electronic device. The electronic device includes a housing and the antenna module according to the second aspect. The antenna module is arranged on the housing.

It may be understood that the electronic device may perform wireless communication with a network device (such as a server and a base station) or another electronic device through the antenna module, to complete an information exchange with the network device or the another electronic device.

### BRIEF DESCRIPTION OF DRAWINGS

FIG. 1(a) to FIG. 1(c) are schematic diagrams of a topology of a matching circuit according to some embodiments of this application;
FIG. 2 is a schematic diagram of a mobile phone according to an embodiment of this application, where FIG. 2(a) is a three-dimensional view of the mobile phone, and FIG. 2(b) is an exploded view of the mobile phone;
FIG. 3 is an example structural diagram of an antenna module in the mobile phone according to an embodiment of this application;
FIG. 4 is a schematic structural diagram of a radio frequency front-end device according to some technical solutions;
FIG. 5 is a schematic structural diagram of a radio frequency front-end device according to an embodiment of this application;
FIG. 6 is an example structural diagram of a radio frequency front-end device with a filter F₇ being removed according to some embodiments of this application;
FIG. 7 is a schematic structural diagram of a radio frequency front-end device having two common signal terminals ANT according to some embodiments of this application;
FIG. 8(a) is a schematic structural diagram of an antenna switch ASW in the radio frequency front-end device in FIG. 6;
FIG. 8(b) is a schematic structural diagram of an antenna switch ASW according to another technical solution;
FIG. 9 is a schematic diagram of a switch S₈ in a radio frequency module in the radio frequency device according to some embodiments of this application; and
FIG. 10 is an example structural diagram of the radio frequency front-end device according to an embodiment.

DESCRIPTION OF REFERENCE NUMERALS: 1-Mobile phone; 10-Antenna module; 100-Antenna; 200-Radio frequency front-end device; 210-Radio frequency module; ASW-Antenna switch; S₁-S₁₀-Switch; S₁₁-S₅₂-Switch; a1-First end; a7-a10-First end; b1-b10-Second end; F₁-F₇-Filter; Ø1-Ø8-Matching circuit; 220-Circuit board; 221-First pin; ANT-Common signal terminal; ANT1-Common signal terminal; ANT2-Common signal terminal; 200a-Radio frequency front-end device; 210a-Radio frequency module; S₁ₐ-S₈ₐ-Switch; S₁₁ₐ-S₆₂ₐ-Switch; F₁ₐ-F₇ₐ-Filter; 220a-Circuit board; 300-Transceiver; 20-Baseband chip; 30-Display; 40-Middle frame; 50-Housing.

### DESCRIPTION OF EMBODIMENTS

To make objectives, technical solutions, and advantages of this application clearer, implementations of this application are further described in detail below with reference to drawings.

It should be understood that "a plurality of" mentioned in this application means two or more. In the descriptions of this application, unless otherwise specified, "/" means "or". For example, A/B may mean A or B. In this specification, "and/or" merely describes an association relationship between associated objects, and indicates that three relationships may exist. For example, A and/or B may indicate the following three cases: only A exists, both A and B exist, and only B exists. Moreover, for ease of describing the technical solutions of this application clearly, terms such as "first" and "second" are used for distinguishing between same or similar items with substantially same functions and effects. A person skilled in the art may understand that the terms such as "first" and "second" do not limit a quantity or an execution sequence, and the terms such as "first" and "second" unnecessarily define a difference.

For ease of understanding the technical solutions of this application, some technical terms and related concepts involved in embodiments of this application are first described.

### (1) Wireless communication band

As wireless communication technologies develop, communication may be performed in a plurality of different wireless communications standards, such as 3G, 4G (or referred to as "LTE"), 5G, and Wi-Fi. Different communication standards have different operating bands. For example, a partial operating band of the 3G standard is in a range of 2010-2025 MHz, and a partial operating band of the 5G standard is in a range of 4800-4900 MHz.

A same communication system may include a plurality of sub-bands. Table 1 shows example sub-bands in the LTE standard. Referring to Table 1, the LTE standard includes a plurality of sub-bands. Each sub-band may be represented by a band number in a format of "Bx". For example, an uplink band range "1920-1980 MHz" and a downlink band range "2110-2170 MHz" may be represented by a band number of B1.

**Table 1 Sub-bands of the LTE standard**

| Bx | Uplink band (i.e., transmitting band) | Downlink band (i.e., receiving band) |
|---|---|---|
| B1 | 1920-1980 MHz | 2110-2170 MHz |
| B3 | 1710-1785 MHz | 1805-1880 MHz |
| B7 | 2500-2570 MHz | 2620-2690 MHz |
| B29 | - | 717-728 MHz |
| B32 | - | 1452-1496 MHz |
| B39 | 1880-1920 MHz | 1880-1920 MHz |
| B40 | 2300-2400 MHz | 2300-2400 MHz |
| B41 | 2496-2690 MHz | 2496-2690 MHz |

In a practical application, different countries or regions or different operators in a same country may use different operating bands. For example, an LTE band used by an operator A is a B1/B3 band, and an LTE band used by an operator B is a B1/B7 band. For example, some operators in Europe require a terminal device to support a B32 band, while others do not.

### (2) Carrier aggregation (CA) technology

It is a technology in which a plurality of carriers are combined to simultaneously transmit data on the plurality of carriers. For example, a plurality of middle high bands (Middle High Band, MHB) (such as the B1 band, the B2 band, and the B7 band) are aggregated. The carrier aggregation technology can increase a transmission bandwidth, thereby increasing a data transmission rate.

### (3) Matching circuit

The matching circuit is configured to adjust an impedance characteristic of an electromagnetic wave transmission link, to improve transmission efficiency of a transmission link. The matching circuit is generally composed of one or more passive devices. For example, the matching circuit may be composed of one or more inductors. The inductors may be implemented by a winding inductor, a substrate inductor, or an on-chip inductor. For another example, the matching circuit may be composed of one or more capacitors. The capacitors may be implemented by a ceramic capacitor, a substrate capacitor, or an on-chip capacitor.

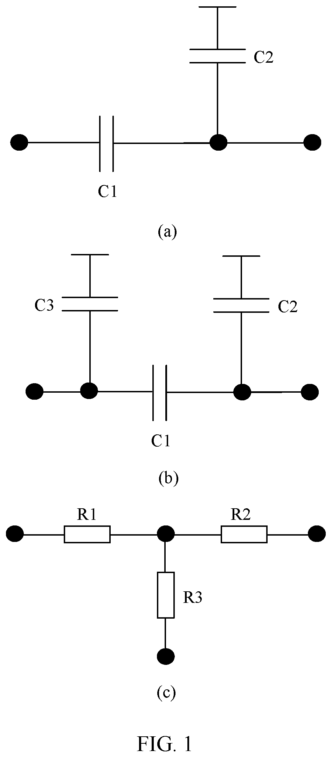

The matching circuit may have a plurality of different topologies, to meet signal transmission demands in a carrier aggregation state and a non-carrier aggregation state. FIG. 1(a) to FIG. 1(c) are schematic diagrams of a topology of a matching circuit according to some embodiments of this application. For example, as shown in FIG. 1(a), the topology of the matching circuit may be L-shaped. In other words, a capacitor C1 and a capacitor C2 form a structure similar to an L shape. For another example, as shown in FIG. 1(b), the topology of the matching circuit may be Pi-shaped. In other words, a capacitor C1, a capacitor C2, and a capacitor C3 jointly form a structure similar to a Pi shape. For example, as shown in FIG. 1(c), the topology of the matching circuit may be T-shaped. In other words, a resistor R1, a resistor R2, and a resistor R3 jointly form a structure similar to a T shape. In addition, it may be understood that FIG. 1 merely provides an example description of a matching circuit structure. In another embodiment, the matching circuit may include components different from those shown in FIG. 1.

Implementations of this application are further described in detail below with reference to the drawings.

This application provides a radio frequency front-end device and an electronic device including the radio frequency front-end device. The radio frequency front-end device provided in embodiments of this application can reduce a quantity of switches in an antenna switch and has good tuning performance.

It may be understood that the electronic device provided in this application may be any one of electronic devices having a wireless communication function, such as a mobile phone, a tablet computer, a notebook computer, a wearable device, a super netbook, an ultra mobile personal computer (ultra mobile personal computer, UMPC), and a personal digital assistant (personal digital assistant, PDA). For ease of description, the solution is described below by using an example in which the electronic device is a mobile phone.

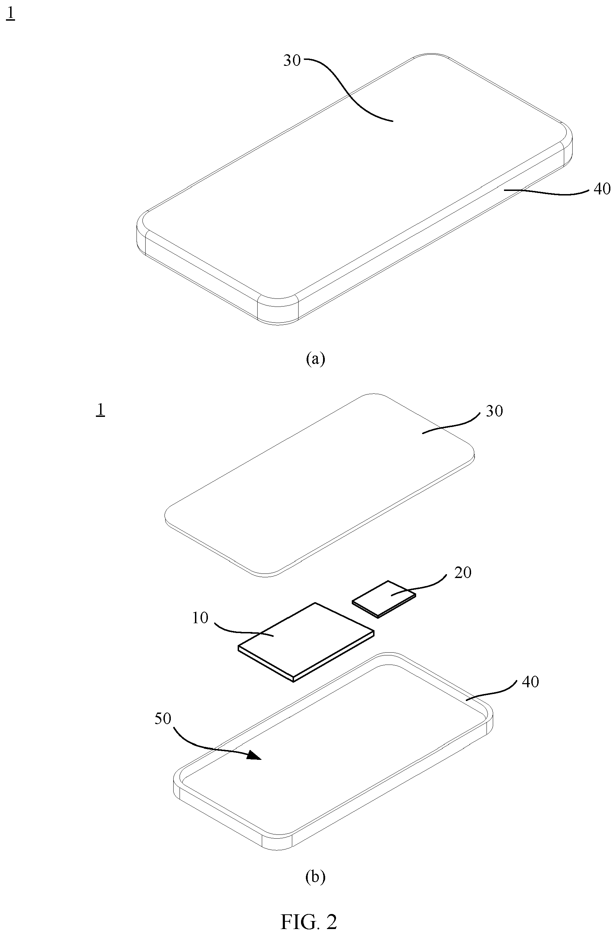

FIG. 2 is a schematic diagram of the mobile phone 1 according to an embodiment of this application, where FIG. 2(a) is a three-dimensional view of the mobile phone 1, and FIG. 2(b) is an exploded view of the mobile phone 1. Referring to FIG. 2, the mobile phone 1 includes an antenna module 10, a baseband chip 20, a display 30, and a rear cover 40.

The display 30 and the rear cover 40 may jointly define an accommodating space 50. The antenna module 10 and the baseband chip 20 are both located in the accommodating space 50. For example, the antenna module 10 and the baseband chip 20 are arranged on a housing 50. The antenna module 10 may be connected to the baseband chip 20, to implement a wireless communication function of the mobile phone 1. For example, in a data sending process, the baseband chip may send a to-be-sent wireless signal (in a digital form) to the antenna module. The antenna module converts a wireless signal into an electromagnetic wave and transmits the signal into a space. In a signal receiving process, the antenna module may receive an electromagnetic wave signal in a space, convert the signal into a digital signal that may be read by the baseband chip, and send the digital signal to the baseband chip.

The signal sending process and the data receiving process are inverse processes. The technical solutions of this application are described below by using the signal receiving process as an example. However, it may be understood that technical principles and effects of this application may also be applied to the signal sending process.

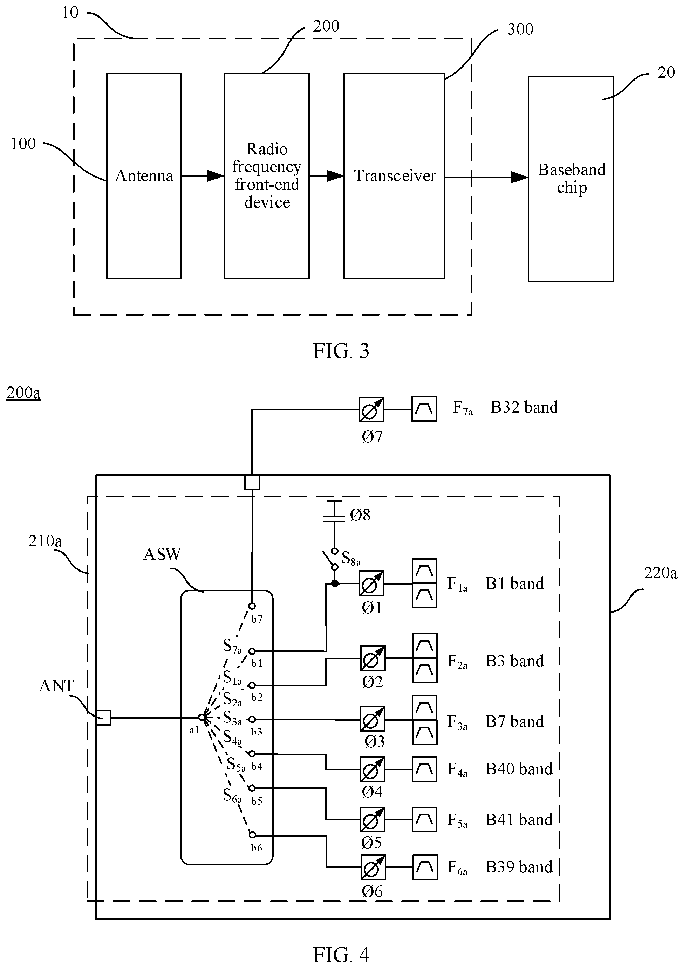

FIG. 3 is an example structural diagram of an antenna module 10 in the mobile phone 1 according to an embodiment of this application. Referring to FIG. 3, the antenna module 10 includes an antenna 100, a radio frequency front-end device 200, and a transceiver 300. The antenna 100, the radio frequency front-end device 200, the transceiver 300, and the baseband chip 20 are connected in sequence.

In the antenna module 10, the antenna 100 is configured to receive an electromagnetic wave signal in a space and convert the electromagnetic wave signal into a radio frequency signal. Next, the antenna transmits the radio frequency signal to the radio frequency front-end device. One or more sets of antennas 100 may be arranged. Each set of antennas 100 may be in a form of a single antenna, an array antenna, or the like.

The radio frequency front-end device 200 may perform filtering on a received radio frequency signal, and then transmit a filtered signal to the transceiver 300. Then the transceiver 300 may perform further processing on the received radio frequency signal (such as amplification and A/D conversion) to convert the radio frequency signal into a baseband signal. Next, the transceiver 300 transmits the baseband signal to the baseband chip 20. Then the baseband chip 20 performs decoding on the baseband signal to extract useful information or data, for example, data representing user data or control information such as a voice, a text, and a video.

It may be understood that the mobile phone 1 may perform wireless communication with a network device (such as a server and a base station) or another electronic device through the antenna module 10 shown in FIG. 3, to complete an information exchange with the network device or the another electronic device.

In addition, it may be understood that the radio frequency front-end device 200, which is an important part of the antenna module 10, is a core component configured to implement a wireless communication function between the mobile phone 1 and other types of mobile terminals.

FIG. 4 is a schematic structural diagram of a radio frequency front-end device 200a according to some technical solutions. As shown in FIG. 4, the radio frequency front-end device 200a includes an antenna switch ASW, seven filters F₁ₐ-F₇ₐ, and a common signal terminal ANT. The antenna switch ASW includes seven switches S₁ₐ-S₇ₐ. Operating bands of the seven filters F₁ₐ-F₇ₐ are respectively a B1 band, a B3 band, a B7 band, a B40 band, a B41 band, a B39 band, and a B32 band.

The switches S₁ₐ-S₇ₐ are respectively in one-to-one correspondence with the filters F₁ₐ-F₇ₐ. An end of each of the switches S₁ₐ-S₇ₐ is connected to the common signal terminal ANT, and another end is connected to a corresponding one of the filters F₁ₐ-F₇ₐ, to form a plurality of transceiver links. For example, a first end a1 of the switch S₁ₐ is connected to the common signal terminal ANT, and a second end b1 thereof is connected to the filter F₁ₐ, to form a transceiver link for a signal in the B1 band (which is referred to as a B1 link below). For another example, the switch S₂ₐ and the switch S₁ₐ share the first end a1, and a second end b2 of the switch S₂ₐ is connected to the filter F₂ₐ, to form a transceiver link for a signal in the B3 band (which is referred to as a B3 link below). By analogy, a transceiver link for a signal in the B7 band (which is referred to as a B7 link below), a transceiver link for a signal in the B40 band (which is referred to as a B40 link below), a transceiver link for a signal in the B41 band (which is referred to as a B41 link below), a transceiver link for a signal in the B39 band (which is referred to as a B39 link below), and a transceiver link for a signal in the B32 band (which is referred to as a B32 link below) may be formed.

The antenna switch ASW may implement carrier aggregation on at least any two of the B1 signal, the B3 signal, the B7 signal, the B32 signal, the B39 signal, the B40 signal, and the B41 signal. For example, when the switch S₁ₐ, the switch S₂ₐ, and the switch S₃ₐ of the antenna switch ASW are simultaneously turned on (in other words, a multi-way function of the antenna switch is performed), the B1 link, the B3 link, and the B7 link are turned on, and the foregoing radio frequency front-end device 200a can implement carrier aggregation on the B1 signal, the B3 signal, and the B7 signal.

Still referring to FIG. 4, in the foregoing radio frequency front-end device 200a, matching circuits Ø1-Ø7 are further respectively arranged between the switches S₁ₐ-S₇ₐ and the corresponding filters. The switches are respectively connected to the corresponding filters through the matching circuits. For example, the second end b1 of the switch S₁ₐ is connected to the filter F₁ₐ through the matching circuit Ø1. For another example, the second end b2 of the switch S₂ₐ is connected to the filter F₂ₐ through the matching circuit Ø2. For connection manners of the remaining matching circuits Ø3-Ø7, refer to FIG. 4. Details are not described herein.

Through the arrangement of the matching circuits, a problem of a signal leakage in a carrier aggregation state can be avoided, and signal transmission performance can be improved.

For example, in a carrier aggregation state of the B1 signal, the B3 signal, and the B7 signal, the B1 link and the B3 link may cause a leakage of the B7 signal. Through the arrangement of the matching circuit Ø1 and the matching circuit Ø2, the B1 link and the B3 link may be brought into a high impedance state relative to the B7 signal, so as to reduce the leakage of the B7 signal from the B1 link and the B3 link. Similarly, topologies of the matching circuits corresponding to the B1 signal and the B3 signal may be adjusted.

In addition, different matching circuits may be needed in a carrier aggregation state and in a non-carrier aggregation state.

For example, in a carrier aggregation state of the B1 signal and the B32 signal, the B1 link may cause a leakage of the B32 signal. To avoid the problem of the leakage of the B32 signal, the topology of the matching circuit of the B1 link needs to be adjusted. Therefore, a matching circuit Ø8 and a switch S8a are further arranged between the switch S₁ₐ and the filter F₁ₐ. An end of the matching circuit Ø8 is separately connected to the second end b1 of the switch S₁ₐ and the matching circuit Ø1 through the switch S₈ₐ.

In the non-carrier aggregation state, the switch S₈ₐ is turned off, the matching circuit Ø1 forms the matching circuit of the B1 link, and the topology of the matching circuit Ø1 may be L-shaped. When the B1 signal and the B32 signal are in the carrier aggregation state, the switch S₈ₐ is turned on, and the matching circuit Ø1 and the matching circuit Ø8 jointly form the matching circuit of the B1 link. The topology of the matching circuit may be Pi-shaped, so that the B1 link is brought into a high impedance state relative to the B32 signal, thereby avoiding the problem of the leakage of the B32 signal.

Operators in different countries or regions have different demands on the carrier aggregation state. For example, a European operator needs to support receiving of a radio frequency signal in the B32 band and carrier aggregation related to the signal, while other regions do not. To meet use needs of different regions and avoid cost wastes, the other components than the filter F₇ₐ and the matching circuit Ø7 may be integrated on a same circuit board (such as a circuit board 220a) or on a same chip. The other components are referred to as a radio frequency module 210a. The filter F7a and the matching circuit Ø7 are arranged outside the radio frequency module 210a. In other words, the foregoing radio frequency front-end device 200a may include the radio frequency module 210a and the filter F₇ₐ and the matching circuit Ø7 arranged outside the radio frequency module 210a. The radio frequency module 210a includes the antenna switch ASW, the common signal terminal ANT, the six filters F₁ₐ-F₆ₐ, the matching circuits Ø1-Ø6, the matching circuit Ø8, and the switch S₈ₐ.

However, because of different manufacturing processes, filters F7 provided by different manufacturers have different impedance characteristics. Therefore, the filters F7 of different manufacturers requires different matching circuits Ø8. For example, when the matching circuit Ø8 is a capacitor, the different filters F7 match different capacitance values. In the manner shown in FIG. 4, the matching circuit Ø8 is integrated on the circuit board 220a. In this case, matching circuits Ø8 adapting to the different filters F7 cannot be flexibly selected based on the different filters F7. As a result, a tuning freedom degree is low, and it is difficult to meet carrier aggregation demands in different operating scenarios.

In addition, in the example shown in FIG. 4, to control an operation of the filter F₇ₐ, the antenna switch ASW needs to include the switch S₇ₐ. As a result, the antenna switch ASW has a large quantity of switches, and therefore the antenna switch ASW occupies a large area. Besides, the large quantity of switches generate a large parasitic capacitance at the common signal terminal ANT.

To resolve the foregoing problem, this application provides a radio frequency front-end device. Through the radio frequency front-end device, a quantity of switches in an antenna switch ASW is reduced, so that an area and a parasitic capacitance of the antenna switch ASW are reduced, thereby improving operating performance of the antenna switch ASW. In addition, through the radio frequency front-end device, free tuning of a matching circuit can be achieved, which meets carrier aggregation demands in different application scenarios. A detailed description is provided below with reference to the drawings.

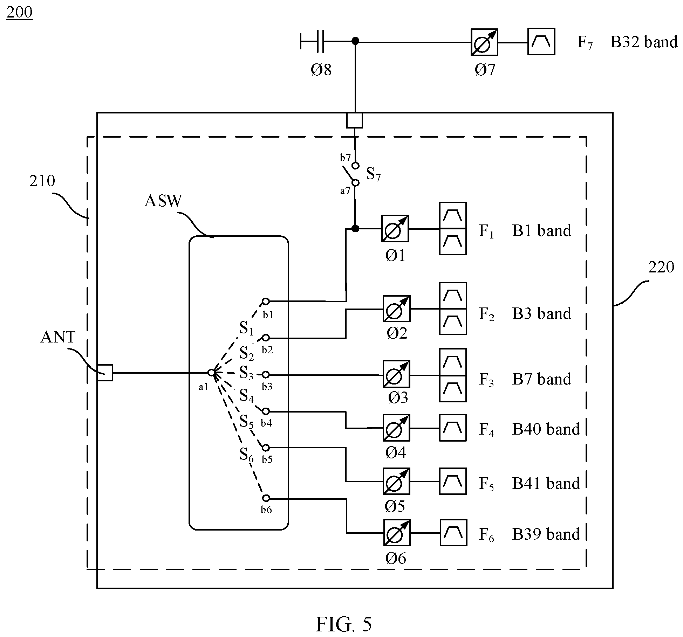

FIG. 5 is a schematic structural diagram of the radio frequency front-end device 200 according to an embodiment of this application. As shown in FIG. 5, the radio frequency front-end device 200 includes the radio frequency module 210, a circuit board 220, and a filter F₇ (serving as a "first external filter") and a matching circuit Ø8 (serving as a "first external matching circuit") arranged outside the radio frequency module 210. In this embodiment, the radio frequency module 210 is integrated on the circuit board 220. Alternatively, in some other embodiments, the radio frequency module 210 may be integrated on a same chip. In this way, the radio frequency module may be used as an electronic component that may be purchased or sold alone.

The radio frequency module 210 includes an antenna switch ASW, filters F₁-F₆, matching circuits Ø1-Ø6, and a common signal terminal ANT. The antenna switch ASW includes six switches S₁-S₆. The switches S₁-S₆ are in one-to-one correspondence with the filters F₁-F₆. The matching circuits Ø1-Ø7 are also in one-to-one correspondence the filters F₁-F₆. An end of each of the switches S₁-S₆ is connected to the common signal terminal ANT, and another end is connected to a corresponding filter through each matching circuit, so as to form a plurality of transceiver links of the radio frequency front-end device 200. Each transceiver link may be configured to support transceiving of a radio frequency signal in a different band.

For example, a first end a1 of the switch S₁ (serving as a "first switch") is connected to the common signal terminal ANT, and a second end b1 is connected to the filter F₁ (serving as a "first filter") through the matching circuit Ø1 (serving as a "first internal matching circuit"). An operating band of the filter F₁ may be a B1 band, to form a B1 link.

For another example, a switch S₂ may share the first end a1 with the switch S₁, and a second end b2 is connected to the filter F₂ through the matching circuit Ø2. An operating band of the filter F₂ may be a B3 band, to form the B3 link.

For connection manners among the switches S₃-S₆, the matching circuits Ø3-Ø6, and the filters F₃-F₆, refer to FIG. 5. Details are not described herein. Operating bands of F₃-F₆ are respectively a B7 band, a B40 band, a B41 band, and a B39 band. It may be understood that the operating bands of F₃-F₆ in FIG. 5 are merely an example description. In another embodiment, the operating bands of the filters F₃-F₆ may be any other wireless communication band.

It may be understood that FIG. 5 merely shows some example structural components included in the radio frequency module 210. Actual structures and locations of these structural components are not limited to FIG. 5. In addition, the radio frequency module 210 may have more or fewer structural components than the structural components shown in FIG. 5. For example, the radio frequency module 210 may further include more filters and matching circuits corresponding to the filters, and the antenna switch ASW may further include more switches to form more transceiver links. For another example, in some embodiments, the radio frequency module 210 may not include any one or more of the matching circuits Ø1-Ø6. For example, each matching circuit may be a phase-shift matching circuit.

For ease of description, connection manners and operating principles of the filter F₇ and the matching circuit Ø8 in the technical solution of this application are first described by using examples in combination with the B1 link.

Still referring to FIG. 5, the radio frequency module 210 further includes a switch S₇ (serving as a "second switch"). The filter F₇ and the matching circuit Ø8 are separately connected to the second end b1 of the switch S₁ through the switch S₇. In other words, the second end b1 of the switch S₁ is connected to a first end a7 of the switch S₇, and the filter F₇ and the matching circuit Ø8 are separately connected to the second end b7 of the switch S₇.

An operating band of the filter F₇ may be flexibly set based on demands of different countries or regions. This is not limited in this application. The technical solution of this application is described below by using an example in which the operating band of the filter F₇ is a B32 band. The switch S₁, the switch S₇, and the filter F₇ jointly form a B32 link. In addition, in this embodiment, the B32 link may further include a matching circuit Ø7, and the second end b7 of the switch S₇ is connected to the filter F₇ through the matching circuit Ø7. Alternatively, in another embodiment, the B32 link may not include the matching circuit Ø7.

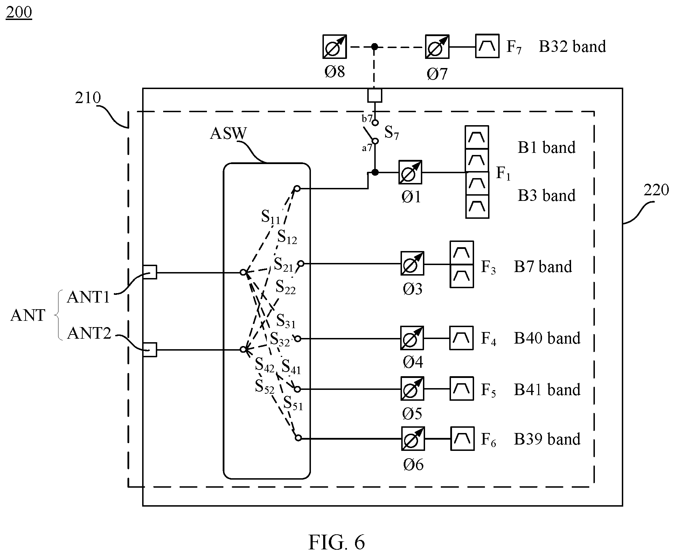

When the switch S₁ and the switch S₇ are simultaneously turned on, the radio frequency front-end device 200 can implement carrier aggregation on the B1 signal and the B32 signal. When the B32 signal is not needed in the mobile phone 1, the filter F₇ may be directly removed. Referring to FIG. 6, when the switch S₇ is turned off, the B32 link is turned off, and the matching circuit Ø8 is disconnected from the matching circuit Ø1. In addition, in some embodiments, when the filter F₇ is not needed in the mobile phone 1, the filter F₇ may be removed from the radio frequency front-end device 200, to avoid an unnecessary space waste, thereby effectively reducing manufacturing costs. Alternatively, when the mobile phone 1 needs to support transceiving of a signal in another band (such as a B29 signal) and carrier aggregation related to the signal, the operating band of the filter may be set to another operating band (such as a B29 band), or the filter F₇ may be replaced with another filter.

Compared with FIG. 4, in FIG. 5, in the foregoing radio frequency front-end device 200, a quantity of switches in the antenna switch ASW is reduced from seven switches to six switches, and an area occupied by and a parasitic capacitance of the antenna switch ASW are reduced. Therefore, operating performance and integration of the radio frequency front-end device 200 are improved.

In the foregoing embodiments, the effect of reducing the quantity of switches of the antenna switch ASW is merely described by using an example in which the antenna switch ASW is connected to a set of antennas 100 through one common signal terminal ANT. In some other embodiments, the radio frequency front-end device 200 may be connected to a plurality of sets of antennas 100 respectively through a plurality of common signal terminals ANT. In this case, the antenna switch ASW has fewer switches.

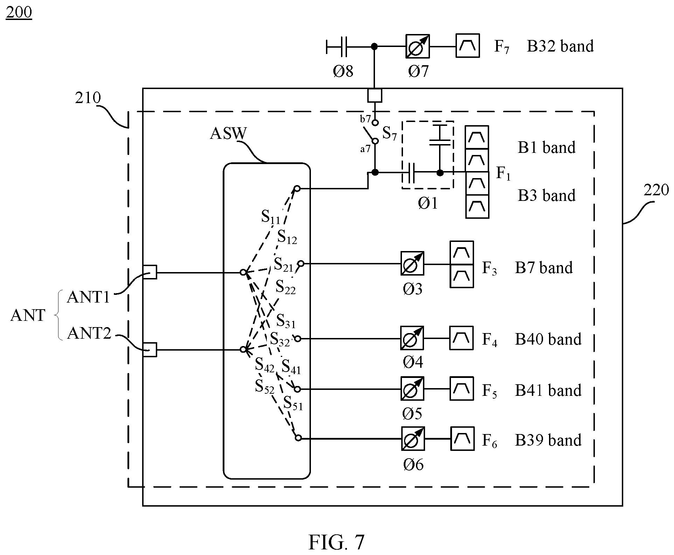

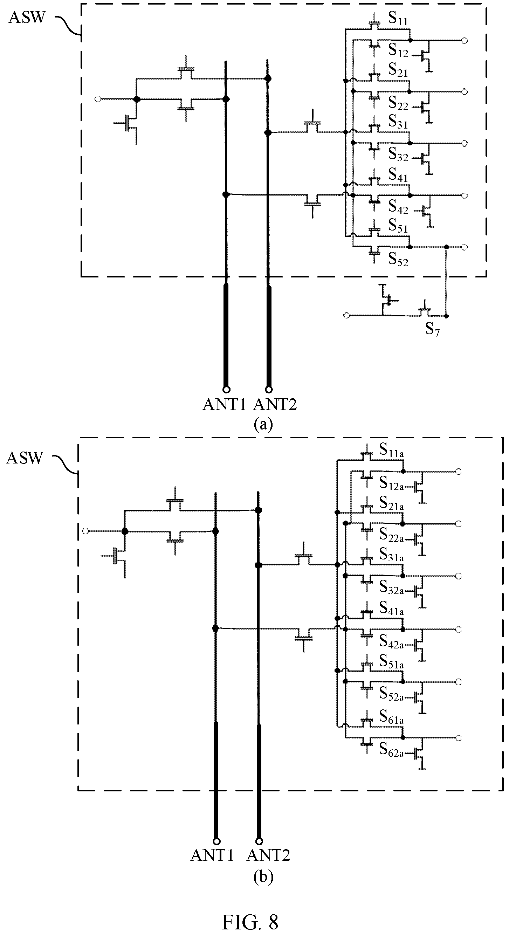

FIG. 7 is a schematic structural diagram of a radio frequency front-end device 200 having two common signal terminals ANT according to some embodiments of this application. FIG. 8(a) is a schematic structural diagram of an antenna switch ASW in the radio frequency front-end device 200 in FIG. 6. FIG. 8(b) is a schematic structural diagram of an antenna switch ASW according to another technical solution.

In the examples shown in FIG. 7 and FIG. 8(a), the radio frequency module 210 includes a first common signal terminal ANT1 and a second common signal terminal ANT2. The first common signal terminal ANT1 and the second common signal terminal ANT2 may be respectively connected to a set of antennas (not shown in the figure). The antenna switch ASW of the radio frequency front-end device 200 includes ten switches S₁₁-S₅₂. Five switches S₁₁, S₂₁, S₃₁, ..., S₅₁ are connected to the first common signal terminal ANT1, and five switches S₁₂, S₂₂, S₃₂, ..., S₅₂ are connected to the second common signal terminal ANT2. In the example shown in FIG. 8(b), the antenna switch ASW includes twelve switches S₁₁ₐ-S₆₂ₐ. Compared with the antenna switch ASW in the another technical solution, two fewer switches are used in the antenna switch ASW in this application, the antenna switch ASW occupies a smaller area, and each switch generates smaller parasitic capacitances at the first common signal terminal ANT1 and the second common signal terminal ANT2.

It may be understood that the radio frequency front-end device 200 may alternatively include more common signal terminals ANT, such as three, four, or five common signal terminals. A larger quantity of common signal terminals ANT leads to a larger quantity by which switches of the antenna switch ASW in the radio frequency front-end device 200 are reduced and a larger area that is reduced.

Still referring to FIG. 5, in addition to implementing the carrier aggregation between the B1 signal and the B32 signal, the foregoing switch S₇ can further change the topology of the matching circuit of the B1 link, to ensure signal transmission performance of the B1 signal and another signal (such as the B32 signal) in the carrier aggregation state and in the non-carrier aggregation state.

Specifically, in the non-carrier aggregation state, the switch S₇ is turned off, and the matching circuit Ø1 forms the matching circuit of the B1 link. The matching circuit Ø1 has a first topology. For example, the first topology may be L-shaped, as shown in FIG. 1(a). In the carrier aggregation state of B1 and B32, the switch S₇ is turned on, and the matching circuit Ø1 and the matching circuit Ø8 jointly form the matching circuit of the B1 link. The matching circuit has a second topology. The second topology is different from the first topology. For example, the second topology may be Pi-shaped, as shown in FIG. 1(b). In this case, the B1 link is brought into a high impedance state relative to the B32 signal, which greatly reduces a possibility that the B32 signal leaks through the B1 link, thereby improving carrier aggregation performance of the radio frequency front-end device 200. In addition, since the matching circuit Ø8 is arranged outside the radio frequency module 210, different matching circuits Ø8 may be flexibly selected for different filters F₇, which effectively increases a tuning freedom degree of the matching circuit.

In some other embodiments, when the filter F₇ is removed, the topology of the matching circuit of the B1 link may be adjusted through S₇, to ensure carrier aggregation performance of the B1 signal with another signal. For example, in a carrier aggregation state of the B1 signal and the B3 signal, the switch S₇ is turned on, and the topology of the matching circuit of the B1 link changes from the first topology (for example, is L-shaped) to the second topology (for example, is Pi-shaped). Therefore, the B1 link is brought into a high impedance state relative to the B3 signal, which reduces a possibility that the B3 signal leaks through the B1 link.

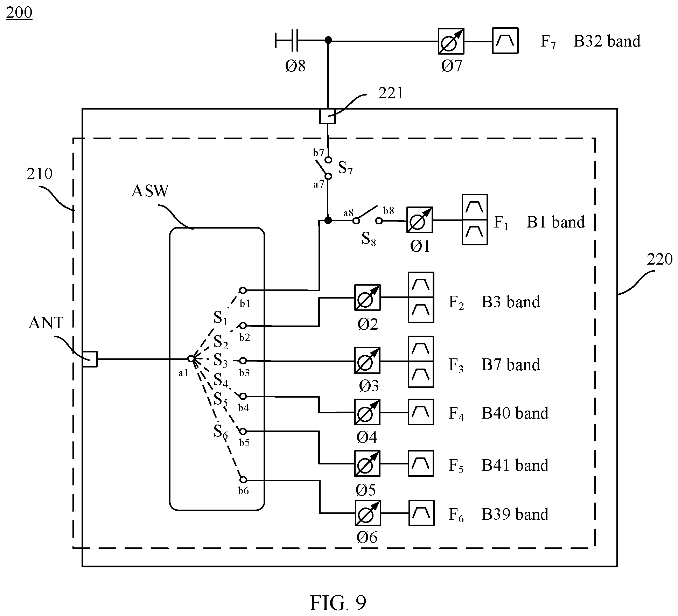

To further improve the signal transmission performance in the carrier aggregation state, the foregoing radio frequency module 210 may further include a switch S₈ (serving as a "third switch"). FIG. 9 is a schematic diagram of the switch S₈ in the radio frequency module 210 in the radio frequency device 200 according to some embodiments of this application.

As shown in FIG. 9, the second end b1 of the switch S₁ and the first end a7 of the switch S₇ are separately connected to a first end a8 of the switch S₈, and the matching circuit Ø1 is connected to a second end b8 of the switch S₈. In other words, the second end b1 of the switch S₁ and the first end a7 of the switch S₇ are separately connected to the matching circuit Ø1 through the switch S₈.

The switch S₈ can control connection or disconnection between the switch S₁ and the filter F₁. Specifically, when carrier aggregation between signals other than the B1 signal and the B32 signal is needed, the switch S₈ may be turned off to avoid interference among the signals. For example, in a carrier aggregation state of the B3 signal and the B32 signal, the switch S₁, the switch S₂, and the switch S₇ are turned on, and the switch S₈ is turned off. In other words, the B1 link is turned off, and the B3 link and the B32 link are turned on. In this way, it is ensured that the B1 link does not cause interference to transmission of the B3 signal and the B32 signal, thereby effectively improving the signal transmission performance of the radio frequency front-end device 200 in the carrier aggregation state.

In some embodiments of this application, the circuit board 220 may further include a first pin 221. The filter F₇ and the matching circuit Ø8 are separately connected to the second end b7 of the switch S₇ through the first pin 221.

In some embodiments of this application, the filters F₁-F₇ each may be either a surface acoustic wave (Surface Acoustic Wave, SAW) filter or a bulk acoustic wave (Bulk Acoustic Wave, BAW) filter. The filters F₁-F₇ are separately connected to the foregoing transceiver 300.

In some embodiments of this application, the filters F₁-F₇ each may have a plurality of different operating bands. The filter F₁ shown in FIG. 6 and FIG. 7 is used as an example. The filter F₁ has two operating bands, namely, the B1 band and the B3 band.

It may be understood that the layouts of the filter F₇, the matching circuit Ø8, the switch S₇, and the switch S₈ are merely example descriptions of the technical solutions of this application, and a person skilled in the art may make another modification. For example, in this embodiment, the filter F₇, the matching circuit Ø8, the switch S₇, and the switch S₈ can implement the carrier aggregation on the B1 signal and the B32 signal. In another embodiment, the radio frequency front-end device 300 may further include more components (for example, more switches, filters, and matching circuits) to implement carrier aggregation on signals in more bands to adapt to more different application scenarios.

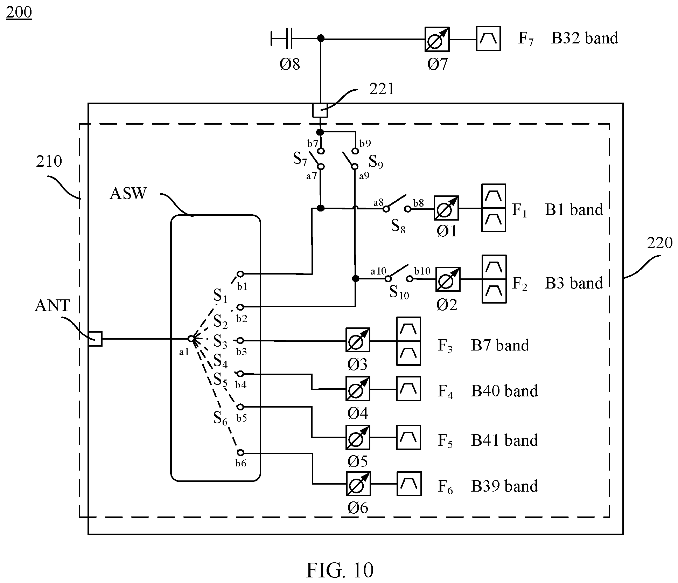

In some embodiments, the radio frequency module 210 may have a plurality of links for aggregation with the B32 link. FIG. 10 is an example structural diagram of the radio frequency front-end device 200 according to an embodiment. As shown in FIG. 10, the first end a1 of the switch S₂ (serving as a "fourth switch") of the antenna switch ASW of the radio frequency front-end device 200 is connected to the common signal terminal ANT, and the second end b2 is connected to the filter F₂ (serving as a "second filter") through the matching circuit Ø2. The radio frequency module 210 further includes a switch S₉ (serving as a "fifth switch"). The second end b2 of the switch S₂ is connected to a first end a9 of the switch S₉, and the filter F₇ and the matching circuit Ø8 are separately connected to a second end b9 of the switch S₉. In other words, the filter F₇ and the matching circuit Ø8 are separately connected to the second end b2 of the switch S₂ through the switch S₉.

For example, the operating band of the filter F₂ may be the B3 band. In this case, the switch S₂ and the filter F₂ jointly form the B3 link. The operating band of the filter F₇ may be the B32 band. In this case, the switch S₂, the switch S₉, and the filter F₇ jointly form a B32 RX. When the switch S₂ and the switch S₉ are simultaneously turned on, the radio frequency front-end device 200 can implement carrier aggregation on the B3 signal and the B32 signal.

Similar to the foregoing switch S₇, in addition to implementing the carrier aggregation between the B3 signal and the B32 signal, the switch S₉ can further change the topology of the matching circuit of the B2 link, to ensure signal transmission performance of the B3 signal and another signal (such as the B32 signal) in the carrier aggregation state and in the non-carrier aggregation state. A principle of changing the topology of the matching circuit of the B2 link through the switch S₉ is the same as a principle of changing the topology of the matching circuit of the B1 link through the foregoing switch S₇, and therefore is not described in detail herein again.

Still referring to FIG. 9, the radio frequency module 210 may further include a switch S₁₀ (serving as a "sixth switch"). The second end b2 of the switch S₂ and the first end a9 of the switch S₉ are separately connected to a first end a10 of the switch S₁₀, and the matching circuit Ø2 is connected to a second end b10 of the switch S₁₀. Through the switch S₁₀, the signal transmission performance of the radio frequency front-end device 200 in the carrier aggregation state can be further improved. An operating principle of the switch S₁₀ is the same as the operating principle of the foregoing switch S₈, and therefore is not described in detail herein.

In some other embodiments, another link in the radio frequency module 210 (such as the B7 link) may be aggregated with the B32 link, which are arranged in a manner substantially the same as the arrangement manner of the foregoing B1 link and B3 link.

For another example, in some other embodiments, in addition to the foregoing filter F₇ and matching circuit Ø8, the radio frequency front-end device 200 may further include another external filter and external matching circuit arranged outside the radio frequency module 210 to adapt to carrier aggregation demands in different scenarios. For example, the radio frequency front-end device may further include a second external filter and a second external matching circuit arranged outside the radio frequency module 210. A connection manner between the second external filter and the second external matching circuit and the radio frequency module 210 is the same as the connection manner between the foregoing filter F₇ and matching circuit Ø8 and the radio frequency module 210, and therefore is not described in detail herein. Similarly, an operating band of the second external filter may be set based on an actual need. For example, the operating band of the second external filter may be the B29 band. In this case, the radio frequency front-end device 200 can implement carrier aggregation on another signal (such as the B1 signal, the B3 signal, and the B7 signal) and the B29 signal.

Based on the above, according to the radio frequency front-end device 200 provided in this application, a layout of switches is redesigned, which effectively reduces the area and the parasitic capacitance of the antenna switch ASW. In addition, the matching circuit and the filter are arranged outside the radio frequency module, which improves a tuning freedom degree, thereby enabling the radio frequency front-end device to adapt to signals in different bands, and ensures operating performance in a carrier aggregation state of signals in different bands, thereby expanding an application range of the radio frequency front-end device 200.

## Claims

1. A radio frequency front-end device (200), comprising a radio frequency module (210) and a first external filter (F₇) and a first external matching circuit (Ø8) arranged outside the radio frequency module (210), wherein
the radio frequency module (210) comprises an antenna switch and a first filter (F₁), the antenna switch comprises a first switch (S₁), a first end of the first switch (S₁) is configured to connect to a common signal terminal of the radio frequency module (210), and a second end of the first switch (S₁) is connected to the first filter (F₁); and
the radio frequency module (210) further comprises a second switch (S₇), a first end of the second switch (S₇) is connected to the second end of the first switch (S₁), and the first external filter (F₇) and the first external matching circuit (Ø8) are separately connected to a second end of the second switch (S₇).

2. The radio frequency front-end device (200) according to claim 1, wherein the first switch (S₁) is connected to the first filter (F₁) through a first internal matching circuit (Ø1) arranged in the radio frequency module (210), and the first internal matching (Ø1) circuit has a first topology.

3. The radio frequency front-end device (200) according to claim 2, wherein when the second switch (S₇) is turned on, the first internal matching circuit (Ø1) and the first external matching circuit (Ø8) jointly form a matching circuit having a second topology, and the second topology is different from the first topology.

4. The radio frequency front-end device (200) according to claim 1, wherein a third switch (S₈) is further arranged between the second end of the first switch (S₁) and the first filter (F₁), and the third switch (S₈) is configured to control connection or disconnection between the second end of the first switch (S₁) and the first filter (F₁).

5. The radio frequency front-end device (200) according to claim 1, wherein the radio frequency module (210) is integrated on a same circuit board (220) or a same chip.

6. The radio frequency front-end device (200) according to claim 5, wherein the circuit board (220) comprises a first pin (221), and the first external filter (F₇) and the first external matching circuit (Ø8) are separately connected to the second end of the second switch (S₇) through the first pin (221).

7. The radio frequency front-end device (200) according to any one of claims 1 to 6, wherein the radio frequency module (210) further comprises a second filter (F₂), the antenna switch further comprises a fourth switch (S₂), a first end of the fourth switch (S₂) is configured to connect to the common signal terminal of the radio frequency module (210), and a second end of the fourth switch (S₂) is connected to the second filter (F₂); and
the radio frequency module (210) further comprises a fifth switch (S₉), a first end of the fifth switch (S₉) is connected to the second end of the fourth switch (S₂), and the first external filter (F₇) and the first external matching circuit (Ø8) are separately connected to a second end of the fifth switch (S₉).

8. The radio frequency front-end device (200) according to claim 7, wherein the fourth switch (S₂) is connected to the second filter (F₂) through a second internal matching circuit (Ø2) arranged in the radio frequency module (210).

9. The radio frequency front-end device (200) according to claim 7, wherein a sixth switch (S₁₀) is further arranged between the second end of the fourth switch (S₂) and the second filter (F₂), and the sixth switch (S₁₀) is configured to control connection or disconnection between the second end of the fourth switch (S₂) and the second filter (F₂).

10. The radio frequency front-end device (200) according to any one of claims 1 to 9, further comprising a second external filter and a second external matching circuit arranged outside the radio frequency module (210), wherein
the radio frequency module (210) further comprises a second filter (F₂), the antenna switch further comprises a fourth switch (S₂), a first end of the fourth switch (S₂) is configured to connect to the common signal terminal of the radio frequency module (210), and a second end is connected to the second filter (Ø2); and
the radio frequency module further comprises a fifth switch (S₉), a first end of the fifth switch (S₉) is connected to the second end of the fourth switch (S₂), and the second external filter and the second external matching circuit are separately connected to a second end of the fifth switch (S₉).

11. The radio frequency front-end device (200) according to any one of claims 1 to 10, wherein an operating band of the first filter (F₁) comprises one of the following: a B1 band, a B3 band, and a B7 band; and/or an operating band of the first external filter (F₇) comprises a B32 band.

12. The radio frequency front-end device (200) according to any one of claims 1 to 11, wherein the radio frequency module (210) comprises one or more common signal terminals.

13. The radio frequency front-end device (200) according to any one of claims 1 to 12, wherein the first filter (F₁) is a surface acoustic wave filter or a bulk acoustic wave filter.

14. An antenna module (10), comprising an antenna (100), a transceiver (300), and the radio frequency front-end device (200) according to any one of claims 1 to 13, wherein the common signal terminal of the radio frequency front-end device (200) is connected to the antenna (100), and the filter of the radio frequency front-end device (200) is connected to the transceiver (300).

15. An electronic device (1), comprising a housing (50) and the antenna module (10) according to claim 14, wherein the antenna module (10) is arranged on the housing (50).

## Patentansprüche

1. Hochfrequenz-Frontend-Vorrichtung (200), umfassend ein Hochfrequenzmodul (210) sowie ein erstes externes Filter (F₇) und eine erste externe Anpassungsschaltung (Ø8), die außerhalb des Hochfrequenzmoduls (210) angeordnet sind, wobei
das Hochfrequenzmodul (210) einen Antennenschalter und ein erstes Filter (F₁) umfasst, wobei der Antennenschalter einen ersten Schalter (S₁) umfasst, wobei ein erstes Ende des ersten Schalters (S₁) dazu konfiguriert ist, mit einem gemeinsamen Signalanschluss des Hochfrequenzmoduls (210) verbunden zu werden, und ein zweites Ende des ersten Schalters (S₁) mit dem ersten Filter (F₁) verbunden ist; und
das Hochfrequenzmodul (210) ferner einen zweiten Schalter (S₇) umfasst, wobei ein erstes Ende des zweiten Schalters (S₇) mit dem zweiten Ende des ersten Schalters (S₁) verbunden ist, und das erste externe Filter (F₇) sowie die erste externe Anpassungsschaltung (Ø8) separat mit einem zweiten Ende des zweiten Schalters (S₇) verbunden sind.

2. Hochfrequenz-Frontend-Vorrichtung (200) nach Anspruch 1, wobei der erste Schalter (S₁) über eine erste interne Anpassungsschaltung (Ø1), die in dem Hochfrequenzmodul (210) angeordnet ist, mit dem ersten Filter (F₁) verbunden ist und die erste interne Anpassungsschaltung (Ø1) eine erste Topologie aufweist.

3. Hochfrequenz-Frontend-Vorrichtung (200) nach Anspruch 2, wobei, wenn der zweite Schalter (S₇) eingeschaltet ist, die erste interne Anpassungsschaltung (Ø1) und die erste externe Anpassungsschaltung (Ø8) gemeinsam eine Anpassungsschaltung bilden, die eine zweite Topologie aufweist, und wobei sich die zweite Topologie von der ersten Topologie unterscheidet.

4. Hochfrequenz-Frontend-Vorrichtung (200) nach Anspruch 1, wobei zwischen dem zweiten Ende des ersten Schalters (S₁) und dem ersten Filter (F₁) ferner ein dritter Schalter (S₈) angeordnet ist und der dritte Schalter (S₈) dazu konfiguriert ist, die Verbindung oder Trennung zwischen dem zweiten Ende des ersten Schalters (S₁) und dem ersten Filter (F₁) zu steuern.

5. Hochfrequenz-Frontend-Vorrichtung (200) nach Anspruch 1, wobei das Hochfrequenzmodul (210) auf derselben Leiterplatte (220) oder demselben Chip integriert ist.

6. Hochfrequenz-Frontend-Vorrichtung (200) nach Anspruch 5, wobei die Leiterplatte (220) einen ersten Pin (221) umfasst und das erste externe Filter (F₇) sowie die erste externe Anpassungsschaltung (Ø8) separat über den ersten Pin (221) mit dem zweiten Ende des zweiten Schalters (S₇) verbunden sind.

7. Funkfrequenz-Frontend-Vorrichtung (200) nach einem der Ansprüche 1 bis 6, wobei das Funkfrequenzmodul (210) ferner einen zweiten Filter (F₂) umfasst, der Antennenschalter ferner einen vierten Schalter (S₂) umfasst, ein erstes Ende des vierten Schalters (S₂) so konfiguriert ist, dass es mit dem gemeinsamen Signalanschluss des Funkfrequenzmoduls (210) verbunden ist, und ein zweites Ende des vierten Schalters (S₂) mit dem zweiten Filter (F₂) verbunden ist; und
das Funkfrequenzmodul (210) ferner einen fünften Schalter (S₉) umfasst, ein erstes Ende des fünften Schalters (S₉) mit dem zweiten Ende des vierten Schalters (S₂) verbunden ist, und der erste externe Filter (F₇) sowie die erste externe Anpassungsschaltung (Ø8) separat mit einem zweiten Ende des fünften Schalters (S₉) verbunden sind.

8. Funkfrequenz-Frontend-Vorrichtung (200) nach Anspruch 7, wobei der vierte Schalter (S₂) mit dem zweiten Filter (F₂) über eine zweite interne Anpassungsschaltung (Ø2) verbunden ist, die im Funkfrequenzmodul (210) angeordnet ist.

9. Funkfrequenz-Frontend-Vorrichtung (200) nach Anspruch 7, wobei ein sechster Schalter (S₁₀) ferner zwischen dem zweiten Ende des vierten Schalters (S₂) und dem zweiten Filter (F₂) angeordnet ist, und der sechste Schalter (S₁₀) so konfiguriert ist, dass er die Verbindung oder Trennung zwischen dem zweiten Ende des vierten Schalters (S₂) und dem zweiten Filter (F₂) steuert.

10. Funkfrequenz-Frontend-Vorrichtung (200) nach einem der Ansprüche 1 bis 9, ferner umfassend einen zweiten externen Filter und eine zweite externe Anpassungsschaltung, die außerhalb des Funkfrequenzmoduls (210) angeordnet sind, wobei
das Funkfrequenzmodul (210) ferner einen zweiten Filter (F₂) umfasst, der Antennenschalter ferner einen vierten Schalter (S₂) umfasst, ein erstes Ende des vierten Schalters (S₂) so konfiguriert ist, dass es mit dem gemeinsamen Signalanschluss des Funkfrequenzmoduls (210) verbunden ist, und ein zweites Ende mit dem zweiten Filter (Ø2) verbunden ist; und
das Funkfrequenzmodul ferner einen fünften Schalter (S₉) umfasst, ein erstes Ende des fünften Schalters (S₉) mit dem zweiten Ende des vierten Schalters (S₂) verbunden ist, und der zweite externe Filter sowie die zweite externe Anpassungsschaltung separat mit einem zweiten Ende des fünften Schalters (S₉) verbunden sind.

11. Funkfrequenz-Frontend-Vorrichtung (200) nach einem der Ansprüche 1 bis 10, wobei ein Betriebsfrequenzband des ersten Filters (F₁) eines der folgenden umfasst: ein B1-Band, ein B3-Band und ein B7-Band; und/oder ein Betriebsfrequenzband des ersten externen Filters (F₇) ein B32-Band umfasst.

12. Hochfrequenz-Frontend-Vorrichtung (200) nach einem der Ansprüche 1 bis 11, wobei das Hochfrequenzmodul (210) einen oder mehrere gemeinsame Signalanschlüsse umfasst.

13. Hochfrequenz-Frontend-Vorrichtung (200) nach einem der Ansprüche 1 bis 12, wobei das erste Filter (F₁) ein Oberflächenwellenfilter oder ein akustisches Volumenwellenfilter ist.

14. Antennenmodul (10), umfassend eine Antenne (100), einen Transceiver (300) und die Hochfrequenz-Frontend-Vorrichtung (200) nach einem der Ansprüche 1 bis 13, wobei der gemeinsame Signalanschluss der Hochfrequenz-Frontend-Vorrichtung (200) mit der Antenne (100) verbunden ist und das Filter der Hochfrequenz-Frontend-Vorrichtung (200) mit dem Transceiver (300) verbunden ist.

15. Elektronische Vorrichtung (1), umfassend ein Gehäuse (50) und das Antennenmodul (10) nach Anspruch 14, wobei das Antennenmodul (10) auf dem Gehäuse (50) angeordnet ist.

## Revendications

1. Dispositif frontal radiofréquence (200), comprenant un module radiofréquence (210) ainsi qu'un premier filtre externe (F₇) et un premier circuit d'adaptation externe (Ø8) agencés à l'extérieur du module radiofréquence (210), dans lequel
le module radiofréquence (210) comprend un commutateur d'antenne et un premier filtre (F₁), le commutateur d'antenne comprend un premier commutateur (S₁), une première extrémité du premier commutateur (S₁) est configurée pour être connectée à une borne de signal commune du module radiofréquence (210), et une seconde extrémité du premier commutateur (S₁) est connectée au premier filtre (F₁) ; et
le module radiofréquence (210) comprend en outre un second commutateur (S₇), une première extrémité du second commutateur (S₇) est connectée à la seconde extrémité du premier commutateur (S₁), et le premier filtre externe (F₇) et le premier circuit d'adaptation externe (Ø8) sont connectés séparément à une seconde extrémité du second commutateur (S₇).

2. Dispositif frontal radiofréquence (200) selon la revendication 1, dans lequel le premier commutateur (S₁) est connecté au premier filtre (F₁) par l'intermédiaire d'un premier circuit d'adaptation interne (Ø1) agencé dans le module radiofréquence (210), et le premier circuit d'adaptation interne (Ø1) présente une première topologie.

3. Dispositif frontal radiofréquence (200) selon la revendication 2, dans lequel, lorsque le second commutateur (S₇) est fermé, le premier circuit d'adaptation interne (Ø1) et le premier circuit d'adaptation externe (Ø8) forment conjointement un circuit d'adaptation présentant une seconde topologie, et la seconde topologie est différente de la première topologie.

4. Dispositif frontal radiofréquence (200) selon la revendication 1, dans lequel un troisième commutateur (S₈) est en outre agencé entre la seconde extrémité du premier commutateur (S₁) et le premier filtre (F₁), et le troisième commutateur (S₈) est configuré pour commander la connexion ou la déconnexion entre la seconde extrémité du premier commutateur (S₁) et le premier filtre (F₁).

5. Dispositif frontal radiofréquence (200) selon la revendication 1, dans lequel le module radiofréquence (210) est intégré sur une même carte de circuit imprimé (220) ou une même puce.

6. Dispositif frontal radiofréquence (200) selon la revendication 5, dans lequel la carte de circuit imprimé (220) comprend une première broche (221), et le premier filtre externe (F₇) et le premier circuit d'adaptation externe (Ø8) sont connectés séparément à la seconde extrémité du second commutateur (S₇) par l'intermédiaire de la première broche (221).

7. Dispositif frontal radiofréquence (200) selon l'une quelconque des revendications 1 à 6, dans lequel le module radiofréquence (210) comprend en outre un second filtre (F₂), le commutateur d'antenne comprend en outre un quatrième commutateur (S₂), une première extrémité du quatrième commutateur (S₂) est configurée pour se connecter à la borne de signal commune du module radiofréquence (210), et une seconde extrémité du quatrième commutateur (S₂) est connectée au second filtre (F₂) ; et
le module radiofréquence (210) comprend en outre un cinquième commutateur (S₉), une première extrémité du cinquième commutateur (S₉) est connectée à la seconde extrémité du quatrième commutateur (S₂), et le premier filtre externe (F₇) et le premier circuit d'adaptation externe (Ø8) sont connectés séparément à une seconde extrémité du cinquième commutateur (S₉).

8. Dispositif frontal radiofréquence (200) selon la revendication 7, dans lequel le quatrième commutateur (S₂) est connecté au second filtre (F₂) par l'intermédiaire d'un second circuit d'adaptation interne (Ø2) agencé dans le module radiofréquence (210).

9. Dispositif frontal radiofréquence (200) selon la revendication 7, dans lequel un sixième commutateur (S₁₀) est en outre agencé entre la seconde extrémité du quatrième commutateur (S₂) et le second filtre (F₂), et le sixième commutateur (S₁₀) est configuré pour commander la connexion ou la déconnexion entre la seconde extrémité du quatrième commutateur (S₂) et le second filtre (F₂).

10. Dispositif frontal radiofréquence (200) selon l'une quelconque des revendications 1 à 9, comprenant en outre un second filtre externe et un second circuit d'adaptation externe agencés à l'extérieur du module radiofréquence (210), dans lequel
le module radiofréquence (210) comprend en outre un second filtre (F₂), le commutateur d'antenne comprend en outre un quatrième commutateur (S₂), une première extrémité du quatrième commutateur (S₂) est configurée pour se connecter à la borne de signal commune du module radiofréquence (210), et une seconde extrémité est connectée au second filtre (Ø2) ; et
le module radiofréquence comprend en outre un cinquième commutateur (S₉), une première extrémité du cinquième commutateur (S₉) est connectée à la seconde extrémité du quatrième commutateur (S₂), et le second filtre externe et le second circuit d'adaptation externe sont connectés séparément à une seconde extrémité du cinquième commutateur (S₉).

11. Dispositif frontal radiofréquence (200) selon l'une quelconque des revendications 1 à 10, dans lequel une bande de fonctionnement du premier filtre (F₁) comprend l'une des bandes suivantes : une bande B1, une bande B3 et une bande B7 ; et/ou une bande de fonctionnement du premier filtre externe (F₇) comprend une bande B32.

12. Dispositif frontal radiofréquence (200) selon l'une quelconque des revendications 1 à 11, dans lequel le module radiofréquence (210) comprend une ou plusieurs bornes de signal commun.

13. Dispositif frontal radiofréquence (200) selon l'une quelconque des revendications 1 à 12, dans lequel le premier filtre (F₁) est un filtre à ondes acoustiques de surface ou un filtre à ondes acoustiques de volume.

14. Module d'antenne (10), comprenant une antenne (100), un émetteur-récepteur (300) et le dispositif frontal radiofréquence (200) selon l'une quelconque des revendications 1 à 13, dans lequel la borne de signal commun du dispositif frontal radiofréquence (200) est connectée à l'antenne (100), et le filtre du dispositif frontal radiofréquence (200) est connecté à l'émetteur-récepteur (300).

15. Dispositif électronique (1), comprenant un boîtier (50) et le module d'antenne (10) selon la revendication 14, dans lequel le module d'antenne (10) est disposé sur le boîtier (50).
